# FASCICULE DE BREVET EUROPEEN

(11) **EP 0 572 514 B1**
(45) Date de publication et mention de la délivrance du brevet: **12.05.1999**
(21) Numéro de dépôt: 92906568.8
(22) Date de dépôt: 18.02.1992
(51) Int. Cl.: H01L 21/603, H01L 23/498, B32B 31/00

(54) **Procédé et dispositif d'assemblage en continu de bandes à motifs**
Verfahren und Vorrichtung zum kontinuierlichen Zusammenfügen von gemusterten Bändern
Method and device for continuous assembling of patterned strips

(30) Priorité: 19.02.1991 FR 9101934
(43) Date de publication de la demande: 08.12.1993
(60) Demande divisionnaire: 96106073.8
(73) Titulaire: GEMPLUS CARD INTERNATIONAL S.A., F-13420 Gémenos (FR)
(72) Inventeur: GLOTON, Jean, Pierre, F-13100 Aix-en-Provence (FR); LAROCHE, Damien, F-13790 Châteauneuf-le-Rouge (FR); TURIN, Joel, F-13008 Marseille (FR); FALLAH, Michel, F-13400 Aubagne (FR)
(86) Numéro de dépôt international: FR9200158
(87) Numéro de publication internationale: WO9215118

(56) Documents cités:
- EP-A- 201 952
- EP-A- 296 511
- EP-A- 391 790
- CH-A- 608 314
- GB-A- 2 031 796
- PATENT ABSTRACTS OF JAPAN vol. 015, no. 114 (E-104)19 Mars 1991 & JP,A,03 004 543 ( RICOH CO LTD ) 10 Janvier 1991
- PATENT ABSTRACTS OF JAPAN vol. 014, no. 174 (M-095)5 Avril 1990 & JP,A,02 026 797 ( IBIDEN CO. LTD ) 29 Janvier 1990
- PATENT ABSTRACTS OF JAPAN vol. 014, no. 401 (E-0971)30 Août 1990 & JP,A,02 150 101 ( SEIKO INSTR INC ) 8 Juin 1990

## Description

La présente invention se rapporte d'une façon générale à un procédé d'assemblage en continu de bandes à motifs.

Elle s'applique notamment à la réalisation de micromodules en circuit intégré, entrant dans la fabrication des cartes plates portables dites "cartes à puce". Dans ces cartes, les micromodules sont formés par un ensemble d'éléments composé : d'une puce en circuit intégré, de contacts métalliques servant de connexion du micromodule avec des dispositifs extérieurs, de fils de liaison pour relier la puce au contacts métalliques et d'une protection formée d'une résine recouvrant la puce, les fils de liaison, et, partiellement les contacts métalliques.

Pour fabriquer un micromodule et l'incorporer ensuite à une carte, un premier procédé connu consiste à reporter la puce sur une bande métallique prédécoupée en forme de grille de conducteur, à souder la puce sur une place de cette grille où elle est reliée par des fils soudés à d'autres plages de la grille, à enrober la puce et les fils par une goutte de résine de protection de type époxy ou silicone en laissant les conducteurs de la grille partiellement dénudés, à découper la bande métallique en micromodules individuels comprenant chacun une puce enrobée et des contacts extérieurs dénudés et à coller le micromodule dans une cavité superficielle d'une carte en matière plastique, de telle sorte que, des portions de grilles non enrobées de résine affleurent et constituent le connecteur extérieur de la carte.

Selon un deuxième procédé également connu, la bande métallique prédécoupée de départ est remplacée par une bande diélectrique métallisée gravée selon un motif de connexion à déterminer. La bande diélectrique forme dans ce cas le support principal de la puce. Les connexions ont une très faible épaisseur et sont obtenues par pré-dépôt d'une couche métallique sur la bande plastique de photogravure de cette couche métallique. La puce est reliée par des fils soudés à des plages de la couche métallisée.

Ces procédés présentent un certain nombre d'inconvénients. Dans le cas d'utilisation d'une bande métallique prédécoupée, la résine d'encapsulation du micromodule adhère mal sur les conducteurs de la grille, ceci d'autant plus que pratiquement la résine se situe d'un seul côté de la bande, l'autre étant réservé pour laisser les conducteurs accessibles pour servir de connecteurs. Il en résulte un problème de fiabilité difficilement soluble, causé principalement par le passage d'humidité entre la résine et les conducteurs.

Dans le cas de l'utilisation d'une bande diélectrique métallisée et photogravée, il faut nécessairement que la bande soit constituée de matière suffisamment rigide et ait une bonne tenue à la température pour ne pas se gondoler lorsque la température s'élève ce qui impose que la définition du motif de conducteur ne soit exécutée que par photogravure sur la bande diélectrique et rend ce deuxième procédé beaucoup plus coûteux qu'un découpage mécanique, par exemple.

Un troisième procédé est connu par la demande de brevet européen publiée sous le n° 0 296 511 déposée sous le n° 88 1097430 le 18 juin 1988.

Cette demande de brevet concerne un procédé de fabrication d'un ruban destiné à fournir des modules pour équiper des cartes électroniques appelées aussi "smart cards". Cependant la solution proposée dans cette demande n'est pas satisfaisante.

En effet, selon ce procédé, on se munit d'une bande métallique dont l'épaisseur est typiquement de 75 micromètres mais qui peut varier entre 50 et 150 micromètres. Cette bande est pourvue de perforations permettant son entraînement et d'ouvertures obtenues par étampage, délimitant les réseaux de conducteurs des circuits. On se munit également d'un ensemble de feuilles isolantes de 125 micromètres d'épaisseur portant sur une face une matière thermoplastique ou thermodurcissable pour un collage à chaud. Les feuilles comportent un ensemble de trous dont la disposition correspond à l'emplacement des connexions et un trou central pour l'emplacement du circuit.

Les feuilles sont collées sur la bande métallique par chauffage. Le chauffage provoque un certain retrait du matériau isolant rendant difficile l'utilisation de feuilles plus grandes surtout dans le sens longitudinal. Avec un collage à froid le problème ne se poserait pas en revanche l'adhérence sur le métal est mauvaise.
D'autre part il est impératif de réaliser une perforation dans chaque feuille d'isolant à l'emplacement réservé pour le circuit afin d'y loger le circuit et de rentrer ainsi dans les tolérances exigées sur l'épaisseur pour la fabrication des cartes à puce.

On peut citer également comme état de la technique le document GB 2031796 A qui décrit un dispositif d'assemblage d'une bande isolante adhésive sur une bande conductrice. Dans le dispositif décrit, le réglage de la tension ne se fait que sur la bande isolante en modifiant la vitesse de rotation des roues entre lesquelles passe cette bande. Un tel dispositif ne permet pas l'emploi de bandes isolantes très fines de 30 à 50 µm comme le permet l'invention.

La présente invention permet de résoudre ces problèmes.

Elle se rapporte d'une façon générale à un procédé d'assemblage en continu de bande à motifs. Outre l'avantage d'une fabrication en continu le procédé selon la présente invention permet également l'emploi d'une bande de matériau isolant beaucoup moins épais que ce qu'il est usuel d'utiliser comme épaisseur d'isolant. Ceci permet de laisser le choix au fabricant en fonction par exemple de l'utilisation qui sera faite, de placer le circuit soit sur la bande d'isolant soit sur la bande métallique. En effet, conformément à l'invention la bande diélectrique peut avoir une épaisseur très faible de l'ordre de 30 à 50 micromètres au lieu de 100 à 200 micromètres.

Le collage d'une puce de circuit intégré peut par conséquent avoir lieu sur la bande diélectrique mince, la formation des connexions électriques à la puce s'effectuant alors à travers des découpes de la bande diélectrique. De toutes les façons l'épaisseur globale du micromodule est ainsi considérablement réduite dans un rapport décisif qui donne la possibilité de fabriquer des cartes à puce très plates.

Dans le cas ou la puce est collée sur la bande diélectrique au lieu d'être collée sur la surface métallique on a un facteur de sécurité supplémentaire, car le diélectrique mince placé sous la puce peut jouer alors un rôle de tampon élastique évitant d'éventuelles détériorations. En outre le procédé conforme à l'invention permet de s'affranchir des incompatibilités rencontrées par la demanderesse lors du collage de la bande diélectrique sur la grille métallique qui doit avoir lieu à une température voisine de 200°C et qui provoque une dilatation différentielle entre les deux matériaux rendant imprécise la juxtaposition des motifs de la bande diélectrique au-dessus de ceux de la grille métallique. Le procédé conforme à l'invention permet de résoudre le problème de la conservation relative des dimensions des motifs dans les directions longitudinales et transversales des bandes et leurs positionnements respectifs lorsque celles-ci sont engagées entre des rouleaux presseurs de machines à coller. Une amorce de solution à ce problème peut consister, par exemple, à prévoir les pas de recouvrement des motifs en fonction, soit de la température attendue de collage, soit de l'élasticité des matériaux des bandes ou en étirant, par exemple, une de deux bandes. Mais l'ajustement des pas de recouvrement en fonction de la température de collage manque de souplesse car le pas de recouvrement des bandes doit alors être modifié chaque fois que la température de collage ou la nature des matériaux constituant les bandes sont modifiées, l'étirage des bandes ne valant généralement que pour des températures et des différences de dilatations faibles.

L'invention propose un procédé d'assemblage en continu de bandes à motifs selon la revendication 1.

La présente invention a également pour objet un dispositif d'assemblage en continu par collage par pression à chaud de bandes à motifs selon la revendication 9.

D'autres caractéristiques et avantages de l'invention apparaîtront à l'aide de la description qui suit faite en regard des dessins annexés qui représentent :
- la figure 1, une vue de dessus d'une bande métallique prédécoupée selon l'invention,
- la figure 2, une vue de dessus d'une bande diélectrique perforée selon l'invention, destinée à être collée sur la bande métallique de la figure 1,
- la figure 3, une vue montrant la juxtaposition des deux bandes en cours de collage,
- la figure 4, un dispositif pour la mise en oeuvre du procédé selon l'invention,
- la figure 5, une représentation d'une presse à pigeonneau utilisée pour la mise en oeuvre du procédé selon l'invention.

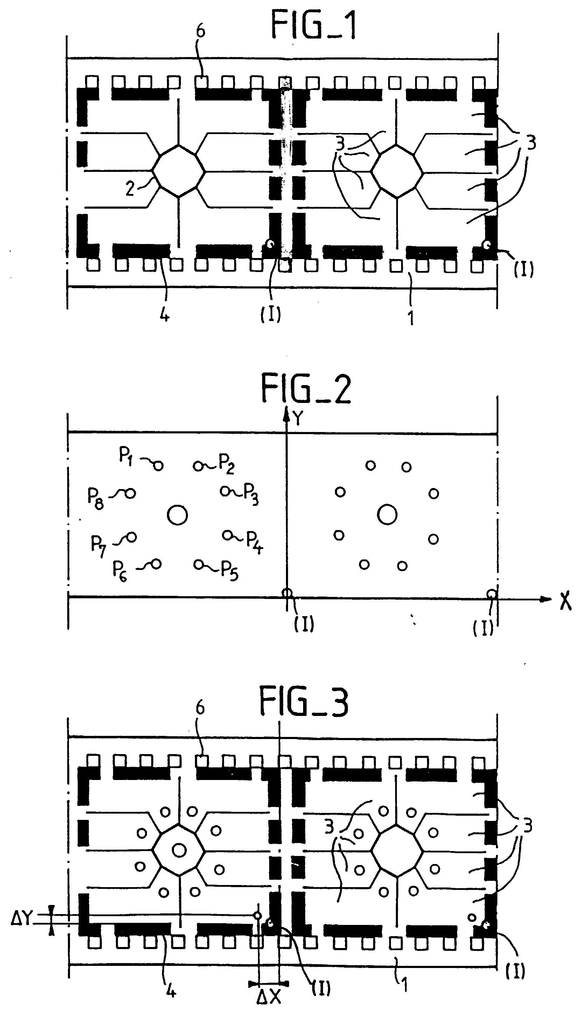

La bande métallique prédécoupée 1 qui est représentée à la figure 1 est formée d'une bande de cuivre ou de cuivre étamé d'épaisseur d'environ 35 à 70 micromètre. Sa largeur est définie pour correspondre à la largeur de connexion finale à réaliser et peut être de l'ordre de 1 cm à quelques centimètres selon les cas. Elle comporte un découpage d'un motif répétitif 2 réalisé éventuellement par matriçage définissant les contacts séparés 3 qui servent de broche de connexion entre l'intérieur et l'extérieur du micromodule à assembler sur le ruban.

Dans la représentation de la figure 1 qui est donnée à titre d'exemple, le motif 2 est celui qui permet la connexion d'un micromodule pour carte à puce plate, les contacts représentés étant au nombre de huit. Les huit contacts séparés 3 sont visibles à l'intérieur d'une ligne fermée 4. Ceux-ci sont séparés par des lignes de découpe des motifs 2. A l'extérieur de la ligne 4, les contacts sont réunis pour assurer la continuité de la bande d'un micromodule à un autre.

La bande 1 comporte des perforations régulières 6 réparties le long des bords longitudinaux de la bande sur un côté ou sur les deux côtés de celle-ci. Ces perforations servent à l'entraînement de la bande par un système à roue dentée.

La bande métallique découpée forme le support principal des puces qui constituent le coeur des micromodules. Cette bande est recouverte d'une bande diélectrique du type de celle représentée à la figure 2 comportant des perforations prédécoupées (P₁ - P₈) destinées à venir en regard des plages conductrices 3 du motif de conducteur découpé dans la bande métallique 1. Un trou d'indexation (I) sert de repère et permet le positionnement précis des perforations (P₁ - P₈) en face des plages conductrices 3 lors de l'opération de collage à chaud des deux bandes l'une contre l'autre.

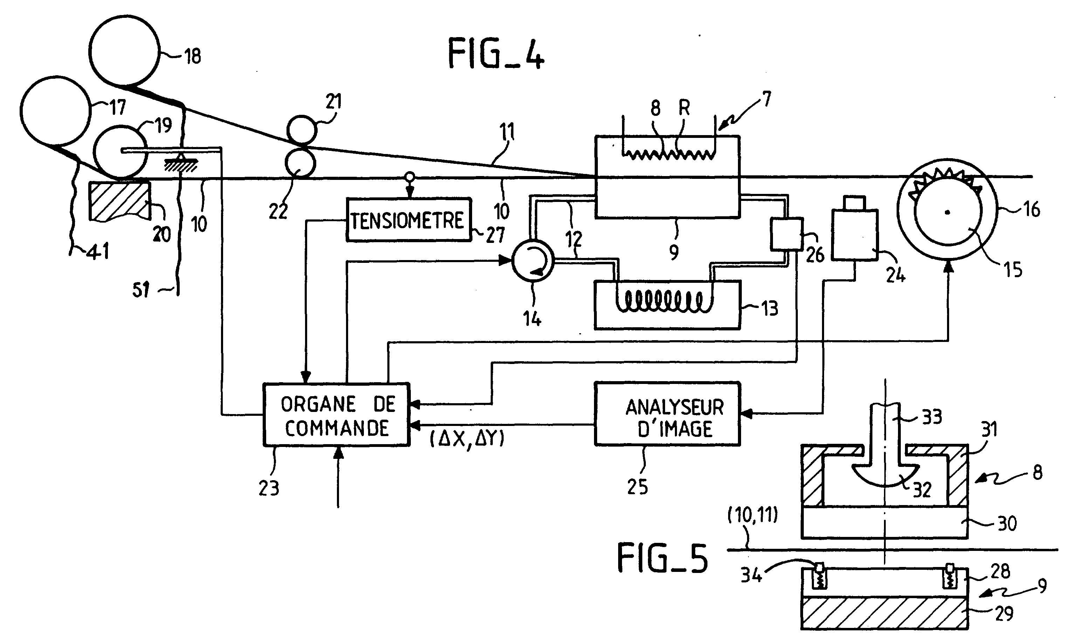

Comme l'indique la figure 3, le trou d'indexation est situé, lorsque l'opération de collage est terminée, à l'intersection de deux axes de collage respectivement horizontal X et vertical Y formés par les lignes de découpe. Ce positionnement est réalisé par le dispositif d'assemblage de bande représenté à la figure 4.

Celui-ci comprend une presse 7 comportant deux plateaux ou éventuellement deux rouleaux 8 et 9 juxtaposés entre lesquels circulent des bandes à motifs 10 et 11 devant être assemblées par collage. Sur la figure 4, le plateau ou le rouleau supérieur 8 est chauffé jusqu'à une température de collage d'environ 200°C par une résistance électrique R alimentée par un dispositif d'alimentation en courant électrique extérieur non représenté. Le plateau inférieur 9 est refroidi par un circuit à circulation d'eau 12 traversant un échangeur de température 13 de type pompe à chaleur, ou tout autre dispositif équivalent actionné par une pompe 14. Les bandes 10 et 11, une fois collées, sont entraînées dans un mouvement de translation entre les deux plateaux ou rouleaux 8 et 9 par une roue à picot 15 dont les dents engrènent dans les perforations 6 de la bande support ou système de pince à mouvement transversal. La roue à picot 15 est mue par un moteur 16. Les bandes 10 et 11 sont dévidées respectivement à partir de deux rouleaux de chargement 17 et 18. En effet afin d'obtenir un assemblage en continu des bandes 10 et 11 celles ci sont chacune montée sur un dérouleur et mu par un moteur non représenté.
La bande 10 est montée sur le rouleau 17, alors que la bande 11 est montée sur le rouleau 18. La bande 10 est enroulée sur elle même avec une bande intercalaire 41 qui tombe au fur et à mesure du déroulement de la bande 10. Cette bande intercalaire 41 permet d'éviter que les motifs ne s'imbriquent les uns dans les autres. La bande 11 est également enroulée sur elle même. Une bande intercalaire 51 peut être prévue aussi pour éviter toute gène lors du déroulement de la bande 11.
La traction de la bande support 10 est réglée par une roue presseuse 19 sur une poutre 20 de la bande support 10. La poutre 20 retient alors la bande 10 par frottement et procure la tension de cette bande. La tension de la bande à coller 11 est réglée par deux rouleaux presseurs 21 et 22 à frottement calibré. Un organe de commande 23 assure d'une part, la commande en rotation du moteur 16 et de la pompe 14 et d'autre part, celle de la roue presseuse 19.
L'organe de commande 23 reçoit des informations provenant d'une part, d'une caméra 24 par l'intermédiaire d'un analyseur d'image 25, d'autre part, d'un capteur de température 26 branché sur le circuit de circulation de fluide 12, ainsi que d'un dispositif 27 formé par un tensiomètre ou tout autre dispositif équivalent pour mesurer la tension de la bande support 10. Ainsi, lorsque les deux bandes 10 et 11 entraînées par la traction du moteur 16 défilent sous les rouleaux ou entre les deux plateaux 8 et 9 l'analyseur d'image 25 peut fournir en permanence des informations de décalage delta X et delta Y du trou repère ou d'indexation relativement aux axes repères X et Y de chaque motif. L'intérêt de cette disposition est qu'elle permet, grâce à l'organe de commande 23, d'agir conjointement ou isolément sur la pression exercée sur la bande 10 ou la bande 11 respectivement, par la roue presseuse 19 pour régler la tension de la bande 10 ou de la bande 11 par les rouleaux presseurs 21 et 22 et par réglage des températures des deux plateaux ou rouleaux presseurs 8 et 9 afin d'ajuster, par extension ou dilatation la position d'une bande par rapport à l'autre pour faire coïncider les pas des motifs des deux bandes en annulant les décalages delta X et delta Y du trou repère par rapport aux axes repères X et Y. Il faut noter cependant qu'un réglage du pas par simple extension d'une des deux bandes l'une par rapport à l'autre ne vaut que pour des faibles décalages delta X et/ou delta Y des valeurs du pas, que les grands décalages ne peuvent être compensés efficacement que par un ajustement des températures relatives des plateaux ou rouleaux 8 et 9 l'une par rapport à l'autre. En pratique, lorsqu'un décalage delta X a dépassé un seuil prédéterminé, la compensation de ce décalage est effectuée par l'organe de commande 23 en agissant sur le refroidissement du plateau 9, dans l'autre cas la compensation s'effectue en agissant sur les rouleaux presseurs 19 ou 21, 22. Cependant, pour que le système fonctionne efficacement il est préférable d'appliquer la bande qui a le coefficient de dilatation le plus important sur le plateau ou rouleau 9 qui est refroidi, l'autre bande 11 étant appliquée contre le plateau ou rouleau 8 qui est chauffé. Ainsi, par exemple, pour un collage d'un rouleau de cuivre qui a un coefficient de dilatation de 17.10⁻⁶/°C sur un rouleau d'une matière plastique commercialisée sous la marque déposée "Kapton" qui a un coefficient de dilatation de 20.10⁻⁶/°C, le Kapton doit être appliqué sur le plateau ou rouleau 9 et le cuivre sur le plateau ou rouleau presseur 8.

Dans l'opération de collage il faut naturellement veiller lorsque les plateaux/rouleaux 8 et 9 viennent en pression, à ce que ceux-ci se déplacent correctement suivant la seule direction Z normale au plan (X, Y) des deux bandes. Le problème peut être résolu facilement en utilisant soit des presses à colonnes soit des presses à pigeonneau avec ressorts de répartition. Cependant, pour éviter d'avoir les positions entre axes qui évoluent avec les températures il est souhaitable d'utiliser, dans le cas des presses à colonnes, des aciers à faible coefficient de dilatation en utilisant par exemple de l'acier commercialisé sous la marque déposée connue Invar, par exemple.

La solution à presse à pigeonneau dont un schéma de réalisation est montré à la figure 5 présente l'avantage d'être de réalisation simple et d'offrir une pression homogène entre les deux plateaux. Comme le représente la figure 5 où les éléments homologues à ceux de la figure 4 sont représentés avec les mêmes références, une presse à pigeonneau comporte un plateau inférieur 9 formé par une plaque en acier 28 montée sur une plaque isolante 29 et un plateau supérieur 8 formé par une plaque en acier 30 comportant une coiffe isolante creuse 31 renfermant la tête 32 d'un pigeonneau 33. La plaque en acier 28 comporte sur la surface en regard avec la plaque en acier 30 des ressorts de répartition 34 qui permettent à la tête de pigeonneau 32, à la plaque d'acier 30 et au ressort 34 d'être en contact tous ensemble avant que la pression des deux plaques 28 et 30 ne soit exercée sur les deux bandes 10 et 11, ce qui évite tout mouvement dans-les directions X et Y lors du serrage des deux plaques.

Une fois le collage réalisé celui-ci peut encore être homogénéisé par éventuellement une deuxième presse non représentée qui a alors les mêmes températures sur les deux plateaux ou par deux rouleaux similaires à ceux déjà utilisés dans l'état de la technique.

Naturellement, le procédé qui vient d'être décrit peut aussi s'appliquer tout aussi efficacement pour assembler de façon indexée tout matériau à motifs de pas identique ou multiple. Le procédé s'applique également au collage d'un nombre quelconque N de bandes en intercalant N presses de pré-collage avant le poste d'homogénéisation. L'intérêt est alors qu'il permet la réalisation de films multicouches en continu.

Ainsi le procédé conforme à l'invention permet la fabrication de micromodules de circuits intégrés, cette fabrication comprenant la formation d'une bande métallique prédécoupée comportant notamment des perforations régulières permettant un entraînement de la bande par roue dentée (à la manière de l'entraînement d'un film de cinéma), la formation d'une bande diélectrique très mince perforée, puis le collage des deux bandes l'une contre l'autre, le collage d'une puce de circuit intégré contre la bande diélectrique mince, et la formation de connexions électriques entre la puce et la bande métallique à travers les découpes de la bande diélectrique. En principe, la bande diélectrique sera plus étroite que la bande métallique, elle ne comportera pas de découpes latérales périodiques permettant un entraînement par roues dentées, et elle sera d'ailleurs en général trop mince pour permettre un entraînement par roue dentée. Lors du collage de la bande diélectrique contre la bande métallique, les découpes permettant l'entraînement de la bande métallique ne seront pas recouvertes par la bande diélectrique grâce à la largeur inférieure de celle-ci.

Les autres opérations de fabrication peuvent être classiques, par exemple : dépôt d'une goutte de résine pour enrober la puce et les connexions de liaison avec la puce, du côté de la bande diélectrique mais pas du côté de la bande métallique; et éventuellement arasage de la goutte à une hauteur prédéterminée; séparation du micromodule d'avec le reste de la bande; le micromodule est alors prêt à être inséré dans une cavité d'une carte plastique.

On remarque en outre que par ce procédé ce n'est plus la bande diélectrique qui sert à entraîner l'ensemble lors de la fabrication en chaîne de micromodules à partir d'une bande continue, comme cela a pu être le cas dans des techniques antérieures lorsqu'une bande diélectrique était prévue. L'épaisseur de la bande diélectrique est beaucoup plus faible que dans l'art antérieur, 30 à 50 micromètres au lieu de 100 à 200 micromètres par exemple. Cela est très important car l'épaisseur globale du micromodule est un facteur décisif pour la possibilité de faire des cartes à puces très plates.

D'autre part, compte-tenu de cette très faible épaisseur, la puce peut être collée sur la bande diélectrique ou sur la bande métallique. Les cas dans lesquels il n'est pas nécessaire de prévoir un contact de face arrière pour la puce sont en effet fréquents en technologie CMOS. Lorsque des contraintes mécaniques s'exercent sur la carte, le diélectrique mince placé sous la carte joue le rôle de tampon élastique ce qui dans certains cas permet d'éviter que la puce ne se détériore.

Lors de la fabrication, la faible épaisseur de la bande diélectrique facilite un collage très efficace des deux bandes l'une contre l'autre, sans risque de décollement lors du traitement ultérieur.

Enfin, un autre avantage de l'invention est que le collage de la puce sur le diélectrique permet de prévoir une seule chaîne de fabrication de micromodules quel que soit la dimension de la puce à encapsuler, et cela à partir d'un seul modèle de bande métallique prédécoupée, à la seule condition de prévoir un outil de découpe modifiable ou amovible pour la formation des découpes dans la bande diélectrique; en effet, la puce est isolée de la grille métallique, et seul l'emplacement des perforations dans le diélectrique définit la position des connexions entre la puce et la grille; pour une puce de plus grande taille, on placera les perforations plus éloignées du centre de la puce; pour une puce plus petite, on rapprochera les perforations du centre; il suffit bien entendu que les perforations restent au dessus des plages métalliques qui conviennent, mais ces plages peuvent être assez larges dans le cas de micromodules à faible nombre de contacts extérieurs (6 ou 8 par exemple).

## Revendications

1. Procédé d'assemblage en continu de bandes à motifs (10, 11) dont l'une est une bande métallique prédécoupée et l'autre une bande d'isolant perforée, ces bandes comportant des repères (I) de pas de motifs et étant dévidées à partir de deux rouleaux de chargement, ce procédé consistant à coller par pression à chaud la première bande (11) sur la deuxième bande (10) au travers d'une presse à coller (8, 9) et à juxtaposer, au moment du collage, les repères de pas de motifs de chaque bande, ce procédé comportant les étapes consistant à repérer sur chacune des bandes les repères de pas de motifs, et ensuite à ajuster les deux bandes l'une par rapport à l'autre par extension d'au moins une bande par rapport à l'autre et/ou par un échauffement différent de chacune des bandes en regard, ce qui provoque un déplacement relatif des deux bandes l'une par rapport à l'autre par dilatation et permet ainsi de juxtaposer les repères de pas de motifs de chaque bande.

2. Procédé selon la revendication 1, dans lequel une presse (7) à plateau est utilisée, comportant un premier plateau (8) chauffé électriquement et un deuxième plateau (9) refroidi par circulation d'un fluide.

3. Procédé selon la revendication 2, dans lequel un organe de commande (23) pour régler les températures des deux plateaux (8, 9) et les tensions des deux bandes (10, 11) est mis en oeuvre.

4. Procédé selon la revendication 2, dans lequel la presse (7) est une presse à pigeonneau (33).

5. Procédé selon l'une quelconque des revendications 1 à 4, dans lequel la position relative des repères des pas des motifs est repérée par une caméra de télévision (24) couplée à un organe de commande (23) par l'intermédiaire d'un analyseur d'image (25).

6. Procédé selon l'une quelconque des revendications 1 à 5, dans lequel la première bande à motifs (10) est en cuivre et la deuxième bande à motifs (11) est en Kapton.

7. Procédé selon l'une quelconque des revendications 2 à 4, et 5 et 6 lorsque que celles-ci dépendent de la revendication 2, dans lequel la bande à motifs (10) qui a le coefficient de dilatation le plus élevé est appliquée sur le deuxième plateau (9) refroidi par circulation d'un fluide.

8. Procédé selon l'une quelconque des revendications précédentes, dans lequel les pas de motifs des bandes (10, 11) sont identiques ou sont des multiples.

9. Dispositif d'assemblage en continu par collage par pression à chaud au travers d'une presse à coller de bandes à motifs (10, 11) dont l'une est une bande métallique prédécoupée et l'autre est une bande d'isolant préperforée, ces bandes comportant des repères (I) de pas de motifs, le dispositif comportant des moyens de chargement des bandes comprenant un premier dérouleur de bandes (17) sur lequel est montée la bande métallique (10) enroulée sur elle-même avec une bande intercalaire (41) empêchant l'imbrication des motifs, un deuxième dérouleur de bande (18) sur lequel est montée la bande d'isolant (11), ladite bande étant enroulée sur elle-même, le dispositif comportant en outre des moyens de repérage (23, 24, 25) des repères de pas de motifs de chaque bande, des moyens de réglage de la tension (19, 21, 22, 23) de l'une ou de l'autre bande et des moyens d'ajustage (8, 9) de cette tension aptes à provoquer un échauffement différent de chacune des bandes en regard, de manière à réaliser un déplacement relatif des deux bandes l'une par rapport à l'autre par dilatation et à juxtaposer les repères de pas de motifs de chaque bande.

10. Dispositif selon la revendication 9, dans lequel la presse à coller est une presse (7) à plateau comprenant un premier plateau (8) chauffé électriquement et un deuxième plateau (9) refroidi par circulation d'un fluide.

11. Dispositif selon la revendication 10, comprenant en outre des moyens de commande (23) pour régler les températures des deux plateaux (8, 9).

12. Dispositif selon la revendication 11, dans lequel les moyens de commande (23) permettent de régler les tensions des deux bandes.

13. Dispositif selon la revendication 10, dans lequel la presse (7) est une presse à pigeonneau (33).

14. Dispositif selon la revendication 9, dans lequel les moyens de repérage comprennent une caméra de télévision (24) couplée à un organe de commande (23) par l'intermédiaire d'un analyseur d'image (25).

15. Dispositif selon l'une quelconque des revendications 9 à 14, dans lequel la première bande à motifs (10) est en cuivre et la deuxième bande à motifs est en Kapton.

## Claims

1. A method for the continuous assembly of pattern strips (10, 11) one of which is a precut metal strip and the other a perforated separator strip, the two comprising pattern step marks (I) and being fed out from two feed rollers, this method consisting in hot pressure gluing the first strip (11) to the second strip (10) using a gluing press (8, 9) and juxtaposing the pattern step markers on each strip simultaneously when gluing; this method comprising various steps involving the locating of the pattern step markers on each of the strips, and then the alignment of the two strips with respect to each other by stretching at least one strip with respect to the other and/or by differentially heating each of the two opposed strips to create a relative displacement of one strip with respect to the other due to the thermal expansion and thus enabling the pattern step markers on each strip to be juxtaposed.

2. A method in accordance with claim 1, in which a plate press (7) is used comprising one plate (8) that is electrically heated and a second plate (9) that is cooled with a liquid coolant.

3. A method in accordance with claim 2, in which a control device (23) is used for controlling the temperature of the two plates (8, 9) and adjusting the tension on the two strips (10, 11).

4. A method in accordance with claim 2, in which the press (7) is a ram press (33).

5. A method in accordance with one of claims 1 to 4, in which the relative position of the pattern step markers is determined by a television camera (24) connected to a control device (23) via an image analyzer (25).

6. A method in accordance with one of claims 1 to 5, in which the first pattern strip (10) is made of copper and the second pattern strip (11) is made of Kapton.

7. A method in accordance with one of claims 2 to 4, and 5 and 6, when the latter are dependant on claim 2, in which the pattern strip (10) that has the highest thermal expansion coefficient is applied to the second plate (9) cooled with a liquid coolant.

8. A method in accordance with one of the above claims, in which pattern steps of the strips (10, 11) are identical or multiples.

9. A continuous hot pressure-gluing system involving the use of a press that glues pattern strips (10, 11) one of which is a precut metal strip and the other a pre-perforated separator strip, each of these bands comprising pattern step markers (I), the system comprising a strip feeding means consisting of one strip unwinder (17) on which the metal strip (10) is rolled into a spool with a separator strip (11) that prevents the patterns from meshing together, a second strip unwinder (18) on which is mounted the separator strip (11), said strip being rolled into a spool, and the system comprising means (23, 24, 25) for determining the location of the pattern step markers on each strip, means for adjusting the tension (19, 21, 22, 23) of either strip and means for adjusting (8, 9) this tension capable of directly heating each of the opposed strips to cause a relative displacement of the two strips with respect to each other due to thermal expansion and juxtapose the pattern step markers of each strip.

10. A system in accordance with claim 9, in which the gluing press is a plate press (7) comprising an initial plate (8) heated electrically and a second plate (9) cooled with a liquid coolant.

11. A system in accordance with claim 10, further comprising means (23) for controlling the temperature of both plates (8, 9).

12. A system in accordance with claim 11, in which the control means (23) make it possible to adjust tension on both strips.

13. A system in accordance with claim 10, in which the press (7) is a ram press (33).

14. A system in accordance with claim 9, in which the locating means consist of a television camera (24) connected to a control device (23) via an image analyzer (25).

15. A system in accordance with one of claims 9 to 14, in which the first pattern strip (10) is made of copper and the second is made of Kapton.

## Patentansprüche

1. Verfahren zur Zusammenfügung im Dauerbetrieb von Motivstreifen (10, 11), wovon einer ein vorgestanzter Metallstreifen und der andere ein isolierender Lochstreifen ist, wobei diese Streifen Motive-Abstandsmarken (I) aufweisen und von zwei Beschickungsrollen abgewickelt werden, wobei dieses Verfahren darin besteht, den ersten Streifen (11) anhand einer Klebepresse (8, 9) durch Heißdruck auf den zweiten Streifen (10) zu kleben, und beim Kleben die Motive-Abstandsmarken eines jeden Streifens aneinanderzulegen, wobei dieses Verfahren aus Etappen besteht, die darin bestehen auf jedem Streifen die Motive-Abstandsmarken zu erkennen, und dann die beiden Streifen durch Strecken von zumindest eines Streifens in Bezug auf den anderen und/oder durch eine unterschiedliche Erhitzung der beiden sich gegenüberliegenden Streifen aneinander anzupassen, was zu einer relativen, gegenseitigen Verschiebung der beiden Streifen durch Dehnung führt und somit ermöglicht, die Motive-Abstandsmarken der beiden Streifen aneinanderzulegen.

2. Verfahren nach Anspruch 1, bei dem eine Plattenpresse (7) verwendet wird, mit einer ersten elektrisch erhitzten Platte (8) und einer zweiten, durch Umwälzung eines Medium gekühlten Platte (9).

3. Verfahren nach Anspruch 2, bei dem ein Steuerorgan (23) verwendet wird, um die Temperaturen der beiden Platten (8, 9) und die Spannungen der beiden Streifen (10, 11) einzustellen.

4. Verfahren nach Anspruch 2, bei dem die Presse (7) eine Kolbenpresse (33) ist.

5. Verfahren nach einem der Ansprüche 1 bis 4, bei dem die relative Position der Motive-Abstandsmarken von einer Fernsehkamera (24) erkannt wird, die über einen Bildanalysator (25) an einem Steuerorgan (23) angeschlossen ist.

6. Verfahren nach einem der Ansprüche 1 bis 5, bei dem der erste Motivstreifen (10) aus Kupfer und der zweite Motivstreifen (11) aus Kapton besteht.

7. Verfahren nach einem der Ansprüche 2 bis 4, und 5 und 6, wenn diese vom Anspruch 2 abhängen, bei dem der Motivstreifen (10) mit dem höchsten Dehnungskoeffizienten gegen die zweite, durch Umwälzung eines Mediums gekühlte Platte (9) gedrückt wird.

8. Verfahren nach einem der vorstehend genannten Ansprüche, bei dem die Motivabstände der Streifen (10, 11) identisch oder Vielfache sind.

9. Vorrichtung zur Zusammenfügung im Dauerbetrieb durch Heißdruck anhand einer Klebepresse von Motivstreifen (10, 11), wovon einer ein vorgestanzter Metallstreifen und der andere ein isolierender Lochstreifen ist, wobei diese Streifen Motive-Abstandsmarken (I) aufweisen, wobei die Vorrichtung Streifenbeschickungsmittel umfaßt, die aus einem ersten Streifenspender (17), auf dem der um sich selbst aufgewickelte Metallstreifen (10) mit einem dazwischen eingewickelten Streifen (41), der das Überlappen der Motive verhindert, montiert ist, und einem zweiten Streifenspender (18), auf dem der um sich selbst aufgewickelte Isolierstreifen (11) montiert ist, bestehen, wobei die Vorrichtung weiters Erkennungsmittel (23, 24, 25) der Abstandsmarken der Motive eines jeden Streifens, Einstellmittel der Spannung (19, 21, 22, 23) des einen oder anderen Streifens, sowie Anpassungsmittel (8, 9) dieser Spannung umfaßt, die geeignet sind, eine unterschiedliche Erhitzung der sich gegenüberliegenden Streifen zu bewirken, um eine relative, gegenseitige Verschiebung der Streifen durch Dehnung herzustellen, und die Motive-Abstandsmarken der beiden Streifen aneinanderzulegen.

10. Vorrichtung nach Anspruch 9, bei der die Klebepresse eine Plattenpresse (7) ist, mit einer ersten, elektrisch erhitzten Platte (8) und einer zweiten, durch Umwälzung eines Mediums gekühlten Platte (9).

11. Vorrichtung nach Anspruch 10, mit u.a. Steuermitteln (23) zur Einstellung der Temperaturen der beiden Platten (8, 9).

12. Vorrichtung nach Anspruch 11, bei der die Steuermittel (23) ermöglichen, die Spannungen der beiden Streifen einzustellen.

13. Vorrichtung nach Anspruch 10, bei der die Presse (7) eine Kolbenpresse (33) ist.

14. Vorrichtung nach Anspruch 9, bei der die Erkennungsmittel eine Fernsehkamera (24) umfassen, die über einen Bildanalysator (25) an einem Steuerorgan (23) angeschlossen ist.

15. Vorrichtung nach einem der Ansprüche 9 bis 14, bei dem der erste Motivstreifen (10) aus Kupfer und der zweite Motivstreifen aus Kapton besteht.
